# EUROPEAN PATENT APPLICATION

(11) **EP 1 707 649 A2**
(43) Date of publication of application: **04.10.2006**
(21) Application number: 06251690.1
(22) Date of filing: 28.03.2006
(51) Int. Cl.: C23C 16/30, C23C 14/06

(54) **Method for coating surfaces with a mixture.**

(30) Priority: 01.04.2005 US 97731
(71) Applicant: The General Electric Company, Schenectady NY 12345 (US)
(72) Inventor: Ackerman, John Frederick, Laramie Wyoming 82070 (US); Shoupe, Marc P., Cincinnati Ohio 45240 (US)
(74) Representative: Pedder, James Cuthbert

(57) **Abstract**

Coated composite articles and methods of applying the coatings are provided. The composite articles (64) are preferably polymeric composites capable of withstanding temperatures of at least 600 degrees Fahrenheit prior to coating. The coating (60) can be selected to impart resistance to higher temperatures as a result of the reflective properties of the coating (60). Additionally, the coating (60) may be selected to provide desired electrical properties when an electrical current is applied. For example, electrically resistant coatings (60) can impart deicing properties to the component, and may be particularly useful in aircraft components (64). The coatings (60) can thus be selected to impart one or more useful properties to the composite component (64).

## Description

This invention relates to the coating of composite articles and, more particularly, to an economical, effective approach for coating composite components, such as those used in aircraft, with a thin coating of a metal such as aluminum. The coating imparts useful properties to the composite component, such as the rejection of radiant heat by reflection, as well as surface heating through electrical resistance properties of the coating.

A continuing trend is to increase the operating temperature of gas turbine engines, as higher temperatures lead to greater thermodynamic efficiency. The ability of the engine to operate at ever-higher temperatures is limited by the materials used in the engine. A variety of techniques are used to achieve increased operating temperatures of the metals used, specifically, superalloys and titanium.

Another trend in aircraft construction is to provide lightweight, yet structurally sufficient, non-metallic composite materials. While improved composite materials have been developed that are inherently structurally stronger and lighter than their counterpart metal components, the composite components cannot presently be used in extremely high-heat environments such as the combustion flowpath of gas turbine engines.

Another problem encountered in aircraft construction is the tendency of airfoils, engine intakes, fuselages, and other external surfaces to gather ice. Gathering of ice impairs performance by adding weight to the aircraft and interfering with aerodynamic properties of the vehicle and its component parts. Known deicing methods involve spraying of glycol and other chemicals pre-flight, posing serious environmental hazards. Other methods, particularly in military aircraft, involve compressor discharge heating by passing high temperature air through deicing passages constructed of expensive, high-temperature resistant polymeric materials. The cost of constructing compressor passages using such composites is very expensive, but temperature limitations of less expensive, lower-temperature composites makes their use impossible in the prior art.

As a result of the above problems, coatings have become important contributors to the design and operation of aircraft components. For example, heat-resistant coatings have significantly increased temperature capability of modern gas turbine engines. Environmental coatings inhibit corrosive damage to coated aircraft components, allowing the components to operate in hostile environments such as the high-temperature corrosive combustion gas, for which they would otherwise be unsuited. For example, ceramic thermal barrier coatings can be provided to serve as insulation layers overlying environmental coatings that serve as bond coats, such as MCrAIYs. Another type of coating is a layer of an optically reflective material that reflects a portion of the incident radiative heat loading away from the coated article. This type of heat-reflective and heat-rejection coating may be made of a metal or a ceramic adhered to the surface of the protected article. While metallic reflective coatings have been applied to relatively planar composites by low-temperature techniques such as evaporation or sputtering, such techniques have failed when the coated composite component is exposed to temperature of over 150 degree C. Additionally, no reflective coating has been successfully applied to a composite surface having a small radii of curvature.

Other drawbacks of known coatings for composites are that they are relatively expensive to apply, and significantly adversely affect the properties of the underlying substrate article upon which they are deposited. Additionally, it is difficult to apply known coatings evenly, especially to highly curved parts, due to coating equipment requirements and limitations.

There is a need for an approach to applying metallic coatings to composite structures that may be readily and inexpensively utilized to impart the coated composites with properties necessary to operate in high-heat environments, and which does not adversely affect the underlying substrate composite article upon which the coatings are applied.

There is further a need for an approach to applying a coating to a composite structure to permit use of the coated composite structure as a resistive heating element, such as in a heating passage in an airfoil or engine inlet, to impart deicing properties.

The present invention fulfills these needs, and further provides related advantages.

The present invention provides a method of applying a metallic coating to a composite substrate article such as a polymeric composite article of PMR (Polymerization of Monomeric Reactants), BMI (Bismaleimide), AFR700, polysulfones, and other high-temperature composites capable of withstanding exposure to operating temperatures of at least 600 degrees Fahrenheit. The method comprises the steps of supplying a composite component, depositing by chemical vapor deposition an optically reflective and/or electrically resistant coating composition onto the component, wherein the reflective coating composition comprising one or metals selected from aluminum, platinum, beryllium, gold, silver or rhodium.

The invention further provides a reflective-coated composite article wherein the coating aids in preventing excessive heating of the article by reflecting incident radiant energy.

The invention further provides an electrically resistant coated composite article wherein the coating provides desired properties by imparting a resistive heating surface coating to the composite article.

Other features and advantages of the present invention will be apparent from the following more detailed description of the preferred embodiment, taken in conjunction with the accompanying drawings, which illustrate, by way of example, the principles of the invention. The scope of the invention is not, however, limited to the two preferred embodiments.

The invention will now be described in greater detail, by way of example, with reference to the drawings, in which:-
Figure 1 is an elevational view of a gas turbine engine with a variable-geometry exhaust nozzle.
Figure 2 is an enlarged schematic sectional view of the gas turbine engine of Figure 1, showing a variable-geometry-exhaust-nozzle flap and seal assembly in accordance with the present invention.
Figure 3 is a block flow diagram of a first method for practicing the present invention.
Figure 4 is a close-up cross-sectional view of a coated composite component in accordance with the present invention.

The component to which the coatings of the present invention are applied include composites, and preferably polymeric composites such as PMR, BMI, polysulfones, AFR700, and any other polymeric composite capable of withstanding exposure to operating temperatures of at least 600 degrees Fahrenheit. Preferred examples of polymeric composite components to which the reflective coating may be applied include, but are not limited to, exhaust nozzles, afterburner casings, combustor chambers, and other gas turbine engine flowpath parts that experience exposure to extreme heat radiation.

The reflective coating composition of the present invention desirably includes a metal selected from aluminum, beryllium, gold, silver, rhodium or an alloy containing one or more of those metals. After application of the coating composition, the resulting reflective coating is in the form of a thin, optically specular and electrically conducting film having an optical reflectivity greater than .9 and a sheet resistance of about 1 ohm per square inch or greater. Preferably, the coating comprises aluminum deposited by CVD from aluminum alkyls, such as tri-sec-butyl aluminum, tri-isopropyl aluminum, or tri-t-butyl aluminum; or mixed alkyl aluminum halides such as di-s-butyl aluminum chloride, and is applied at intermediate temperatures of about 200 to 380 degrees Celsius and preferably 270-300 Celsius.

In the first, reflective embodiment, the coating is quite thin, both to conserve the expensive metal and to avoid a coating that adversely affects the properties of the underlying composite component. Because the reflective coating is thin, it is preferred to specify its quantity by thickness. Most preferably, the reflective coating is present in an amount of from about 2000 Angstroms (.2 microns) up to about 20000Angstroms (2 microns)

In the second, electrically resistive heating embodiment, a resistive coating is preferably applied to a polymeric material, such as PMR, BMI, polysulfones, AFR700, and any other polymeric composites useful in constructing aircraft. The composite is preferably capable of withstanding exposure to operating temperatures of at least 600 degrees Fahrenheit. Most preferably, the polymeric composite material is a composite structure that requires de-icing properties, for example, airfoils, engine intakes, and fuselage of aircraft. In this embodiment, the resistive coating is also quite thin, both to conserve the expensive metal and to avoid a coating that adversely affects the properties of the underlying composite component. Because the electrically resistive coating is thin, it is preferred to specify its quantity by thickness. Most preferably, the reflective coating is present in an amount of from about 2000 Angstroms (.2 microns) up to about 20000Angstroms (2 microns). By using aluminum as the coating, a reasonable total resistance is guaranteed. For example, an electric resistance of 1 Ohms/square inch has been measured for the above coating thickness wherein the coating comprised aluminum deposited by CVD at 300 degrees C from aluminum alkyl onto a PMR-15 composite component, enabling a 100W/cm² power dissipation at about 100V.

Preferably, the component surface is pre-treated prior to the application of the reflective-coating mixture, so that the coating is distributed directly onto the pre-treated surface. Pre-treatments include one or more of (a) polishing the component surface, and (b) cleaning the composite with acetone, ethanol or other solvent.. Most preferably, pre-treatments (a) and (b) are used together, in the indicated order. Such post-treatment of the coating including polishing to impart a mirror surface having smoothness of RA 10 or smoother can create a surface commensurate with a reflectivity of .9 or greater.

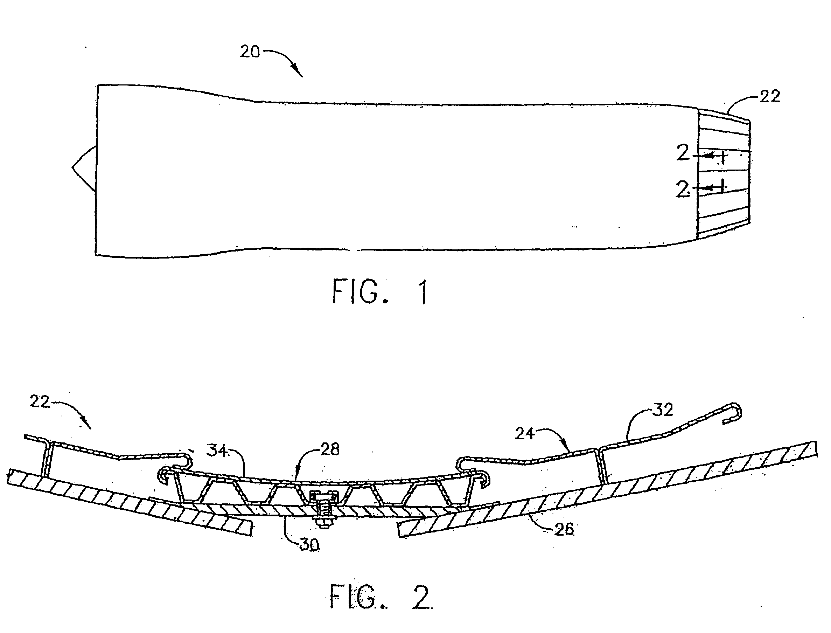

Preferably, the deposition technique is chemical vapor deposition (CVD), although physical vapor deposition (PVD) and/or electrodeposition may be utilized. Such deposition methods may require special chambers or other types of application apparatus. Referring now to the figures, FIG. 1 is an elevational view of an aircraft component in the form of a gas turbine engine 20 with a variable-geometry exhaust nozzle 22, a portion of which is shown in greater detail in the sectional view of FIG. 2. While FIGS. 1 and 2 illustrate an exemplary exhaust nozzle assembly, the present invention is applicable to any polymeric composite substrate, including but not limited to any polymeric composite aircraft part or assembly such as those in compressor discharge systems and deicing assemblies. The exhaust nozzle 22 includes an exhaust nozzle convergent flap 24 and its support 26, and an exhaust nozzle convergent seal 28 and its support 30. This structure extends around the entire circumference of the exhaust nozzle 22. The exhaust nozzle convergent flaps 24 are pivoted inwardly and outwardly to controllably alter the area of the exhaust nozzle, and the exhaust nozzle convergent seals 28 prevent combustion gas leakage between the exhaust nozzle flaps 24. Variable-geometry exhaust nozzle 22 structures of this and other types are known in the art, and FIGS. 1-2 illustrate only the elements of the structure pertinent to one application of the present invention.

The exhaust nozzle convergent flaps 24 and exhaust nozzle convergent seals 28 are heated by the contact of the hot combustion gas flowing through the variable-geometry exhaust nozzle 22, when they are pivoted inwardly to reduce the area of the exhaust nozzle. In a typical case, the inwardly facing surfaces of the exhaust nozzle convergent flaps 24 and the exhaust nozzle convergent seals 28 frequently reach temperatures as high as 1,600°F, absent the heat-rejection coating of the present invention. The present approach provides a technique for coating these elements on their inwardly facing surfaces 32 and 34, respectively, with a heat reflective coating that reduces the temperature of the underlying composite during engine operation.

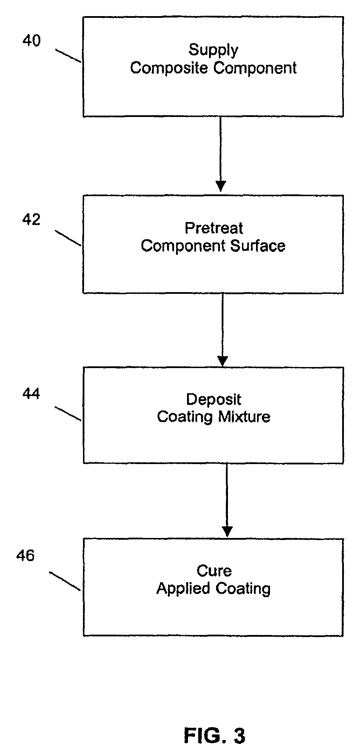

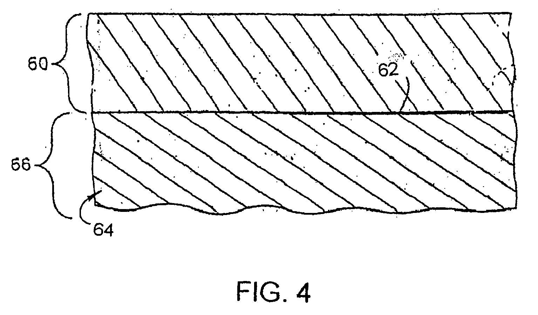

FIG. 3 depicts a preferred method for applying a heat reflective coating, and FIG. 4 (which is not drawn to scale) shows such a heat-reflective and/or electrically resistive coating 60 deposited on a surface 62 of a composite component 64, which serves as a substrate 66 for the coating 60. The composite component 64 is supplied, numeral 40. The composite component 64 is preferably a component of a gas turbine engine, such as the exhaust nozzle convergent flap 24 or the exhaust nozzle convergent seal 28. The composite component 64 is preferably made of PMR, BMI, polysulfones, AFR700, DMBZ, HFBZ, HFPE, and/or any other polymeric composite capable of withstanding exposure to operating temperatures of at least 600 degrees Fahrenheit. Such composites are known in the art. A preferred PMR is PMR-15, however, the present approach may be used with other composites than PMR-15 and those set forth above.

The component surface 62 of the component 64 optionally, but preferably, receives a pre-treatment, numeral 42, such as degreasing, to form a pre-treated component surface. This pre-treatment step 42 removes any materials that may be present from previous processing of the component 64, and is typically achieved by polishing or solvent cleaning of the component surface. The polishing is preferably accomplished using an air grinder with a commercially available Scotch Brite® pad, which is a registered trademark of Minnesota Mining and Manufacturing Company of St. Paul, Minnesota. This polishing removes any pre-existing grease, soot, and scale and desirably produces a surface Ra value of less than about 10. Even when the component surface 62 is degreased, which is a relatively inexpensive step to perform, one of the significant advantages of this embodiment of the present invention is that additional pre-treatments of the component surface 62, which add expense, are not required if the component is not subjected to temperatures exceeding about 600°F.

In a first reflective coating embodiment, once the component has been pre-treated such as by degreasing and/or polishing 44, a reflective coating composition is thereafter directly deposited, in step numeral 54, onto the component surface 62. The reflective coating composition comprises a pure thin film of a selected metal, such as aluminum, beryllium, platinum, gold, silver, or rhodium, but can also be an alloy including any of those metals. Pure aluminum is preferred. A suitable aluminum reflective-coating reagent is tri-sec butyl aluminum, although other aluminum-containing reagents can be utilized using the methods of the present invention.

Where chemical vapor deposition is used, the coating composition is applied using a CVD apparatus to form a coating 60. CVD apparatus generally include a gas generation cell, furnace and exit plumbing with vacuum. The deposition is performed in controlled conditions, that is, in a CVD deposition apparatus, with temperature and low-pressure controls. It is readily performed quickly and inexpensively on components 64 of any size oor shape, including in passages and pores of the component 64, as well as on sharply curved surfaces 62 of the component 64. Chemical vapor deposition, or other deposoition such as vapor phase aluminiding, is performed at elevated temperatures and in most cases in special atmospheric chambers or devices. Preferably, the technique is by CVD from aluminum alkyls, such as tri-sec-butyl aluminum, tri-isopropyl aluminum, or tri-t-butyl aluminum; or mixed alkyl aluminum halides such as di-s-butyl aluminum chloride, and is applied at intermediate temperatures of about 200 to 380 degrees Celsius and preferably 270-300 Celsius. It is preferred that the deposition process 54 applies the coating composition in one layer. The coating 60 is applied in an amount such that the total amount of the coating 60 is present in an amount of from about 0.2 to 2.0 microns in thickness.

One of the significant benefits of CVD is that it allows deposition on the surfaces of internal passageways in pre-formed composite parts such as the air heating passageways in compressor-discharge assemblies of aircraft de-icing systems. Prior to the present invention, the highly curved nature of such surfaces, as well as the composite nature of such components, has prevented the successful coating of the internal surfaces of such passageways prior to this invention. Additionally, the electrical resistance of the coating produced by the present invention renders the surface of the coated component suitable as an electrical resistive heating element. Prior to the present invention, PMI components that required heating had to incorporate a resistive element within the polymeric material of the component, sacrificing homogeneity of the part and compromising its performance and desirable inherent properties. Alternatively, a resistive element was provided in proximity to the article and the heat expected to dissipate through the composite article to reach the surface to be heated. The coated composite article and methods of the present invention are thus a significant and unprecedented improvement over these prior art examples.

Once the component 64 is supplied, numeral 40, the component surface 62 of the component 64 is optionally but preferably pre-treated, numeral 42, to form a pre-treated component surface. There are two types of pre-treatments that are of primary interest, and they may be used independently or together in any operable combination. The following discussion will address all three pre-treatments used in the order indicated in Figure 3, the most preferred pre-treatment approach.

In the first pre-treatment 42, as previously discussed, the component surface 62 is polished, numeral 44, to remove any materials that may be present from previous processing of the component 64. In a second pre-treatment, solvent cleaning, such as with acetone, ethanol, or other volatile solvent is preferred. Where necessary, such as when the composite is provided having a rough surface, it is preferred to use polishing 44 to remove pre-existing contaminants from the surface 62.

## Claims

1. A method of applying a coating to a composite component (64), the method comprising the steps of:
supplying a polymeric composite aircraft component (64);
applying a coating mixture onto the component, wherein the coating mixture comprises a metallic pigment selected from the group consisting of aluminum, beryllium, gold, silver, rhodium, platinum, or an alloy containing one or more of those metals, and a reflective-coating mixture carrier;
and wherein the step of applying is accomplished by a method selected from the group consisting of chemical vapor deposition, physical vapor deposition, and electrodeposition; and
curing the applied coating mixture to form a coating (60) on the component (64).

2. The method of claim 1, wherein the supplied composite component (60) is comprised of a composite material selected from the group consisting of PMR, BMI, polysulfones, AFR700, DMBZ, HFBZ, HFPE, and combinations thereof.

3. The method of claim 2, wherein the composite material of the component (60) is capable of withstanding exposure to operating temperatures of at least 600 degrees Fahrenheit.

4. The method of claim 2, wherein the reflective coating (60) is between about 0.2 microns to about 2.0 microns thick.

5. The method of claim 4, wherein the resulting coating (60) has an optical reflectivity greater than about 0.9.

6. The method of claim 4, wherein the resulting coating (60) has a sheet resistance of at least about 1 ohm per square inch.

7. The method of claim 2, wherein the step of curing includes the step of drying the reflective-coating mixture after applying the reflective-coating mixture.

8. The method of claim 7, wherein the step of drying the reflective-coating mixture is accomplished by allowing the mixture to flash off solvent at ambient temperature for a period of time in the range of about 5 minutes to about 60 minutes.

9. The method of claim 2, wherein the metallic pigment comprises aluminum, and wherein the step of applying is accomplished by chemical vapor deposition from at least one aluminum alkyl.

10. The method of claim 9, wherein the aluminum alkyl is selected from the group consisting of tri-sec-butyl aluminum, tri-isopropyl aluminum, tri-t-butyl aluminum, mixed alkyl aluminum halides, and combinations thereof.
